(19) **European Patent Office**

Europäisches Patentamt

European Patent Office

Office européen des brevets

(11) **EP 1 548 146 B1**

(12) **EUROPEAN PATENT SPECIFICATION**

(45) Date of publication and mention
of the grant of the patent:
**06.12.2006 Bulletin 2006/49**

(51) Int Cl.:
*C23C 14/00* (2006.01)    *C23C 14/06* (2006.01)
*C23C 14/35* (2006.01)

(21) Application number: **04030247.3**

(22) Date of filing: **21.12.2004**

(54) **Method of coating a cutting tool**

Verfahren zur Beschichtung eines Schneidwerkzeuges.

Procédé de formation d'une couche de revêtement sur un outil

(84) Designated Contracting States:
**AT BE BG CH CY CZ DE DK EE ES FI FR GB GR HU IE IS IT LI LT LU MC NL PL PT RO SE SI SK TR**

(30) Priority: **22.12.2003 SE 0303485**

(43) Date of publication of application:
**29.06.2005 Bulletin 2005/26**

(73) Proprietor: **SECO TOOLS AB**
**S-737 82 Fagersta (SE)**

(72) Inventor: **Karlsson, Lennart**
**73733 Fagersta (SE)**

(74) Representative: **Taquist, Henrik Lennart Emanuel et al**
**Sandvik AB,**
**Intellectual Property**
**811 81 Sandviken (SE)**

(56) References cited:
**US-A- 5 776 615**

• **PATENT ABSTRACTS OF JAPAN vol. 017, no. 039 (E-1311), 25 January 1993 (1993-01-25) & JP 04 256313 A (TOSHIBA CORP), 11 September 1992 (1992-09-11)**

**Description**

FIELD OF THE INVENTION

The present invention relates to a method of coating a cutting tool, aimed for machining by chip removal, with a hard and wear resistant nitride layer with low compressive stress. The method for deposition is characterised by the use of reactive magnetron sputtering using a substrate holder, whose projected area is small compared to the target area and by a high electron density current through the substrate, obtained by applying a positive substrate bias.

BACKGROUND OF THE INVENTION

The deposition of wear resistant PVD layers on a cutting tool always implies the use of substrate rotation in order to obtain the best possible coating thickness uniformity around the tool. However, this method is, at closer examination, to be characterised as repeated periods of high deposition rate followed by longer periods without deposition or with low deposition rate, coating-off periods. This periodic deposition rate will affect the coating properties in different ways. First, the average deposition rate will be decreased, which could act as a boost of the in-situ annealing for some coating material systems and therefore reduce the intrinsic residual stress. Secondly, if the deposition rate is decreased too much, and no ultra high vacuum deposition system is used, the surface will be contaminated curing the coating-off period due to adsorption, which in turn enhance the renucleation tendency. This means that commercial single layers are not true single layers but mostly multi-layer in the nanometer regime. This renucleation affects the coating properties in different ways, but will mostly increase the compressive residual stresses as well as the amount of inhomogeneous stresses.

Industrial use of thicker PVD MeN- and/or $Me_2N$-layers on cutting tools has so far been strongly limited due to the compressive stresses normally possessed by such layers. The high biaxial compressive residual stress state will at the cutting edge result in shear and normal stresses which will act as a pre-load of the coating. This pre-load, at a compressive biaxial stress state, will decrease the effective adhesion of the coating to the substrate. When increasing the coating thickness the shear and normal stress at the interface will increase. This effect is the limiting factor for the coating thickness of functional PVD-coatings. Therefore, large efforts during the years have been made to develop PVD processes for deposition of thicker layers with a low compressive residual stress state. Different methods have been applied such as use of low negative substrate bias (between -10 and -50 V), high substrate bias (-400V to -1000V), pulsed bias (unipolar and bipolar) as well as high pressure (above 5 Pa). However, none of these techniques is able to deposit a layer with low intrinsic compressive residual stress state with a maintained dense microstructure without induced defects caused by the rotation of the substrates.

Another approach to reduce the residual Stress State, utilising in-situ annealing during deposition e.g. low deposition rate and/or high deposition temperature, has been tested without success.

US 5,952,085 discloses a multiple layer erosion resistant coating on a substrate comprises alternate layers of tungsten and titanium diboride for gas turbine engines. All of the layers have the same thickness and preferably have thickness of between 0.3 and 1 micrometer to give improved erosion resistance. Magnetron sputtering using a positive bias is used to deposition method of the layers.

EP-A-1245693 discloses low intrinsic residual stress coatings of $TiB_2$ grown by magnetron sputtering from a $TiB_2$ target.

SUMMARY OF THE INVENTION

It is an object of the present invention to provide a method to grow wear resistant nitride layers with reduced compressive residual stress, preferably based on Al and/or Si and/or Cr, onto cutting tools for machining by chip removal.

It is a further object of the present invention to provide a method to grow the layers as microstructurally true single layers with a good coating thickness distribution.

BRIEF DESCRIPTION OF THE DRAWINGS

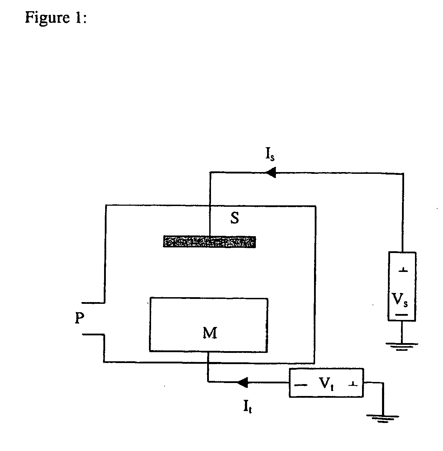

Figure 1 is a schematic description of the deposition system according to present invention, in which

      S is substrate holder,
      M is magnetron including target,
      P is vacuum pump,

$V_t$ target potential,
$V_s$ substrate bias (potential),
$I_s$ substrate current and
$I_t$ target current.

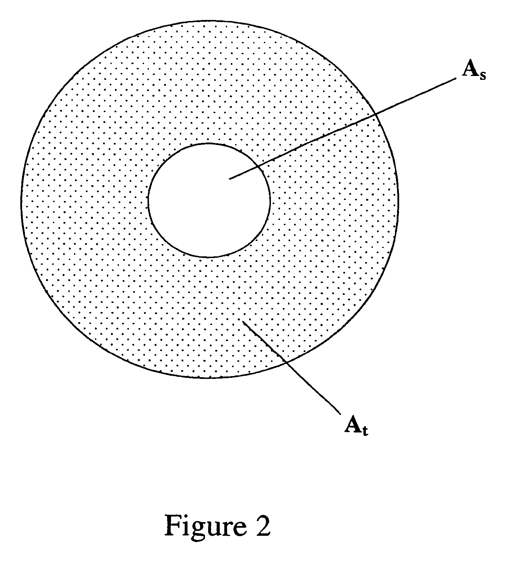

Figure 2 shows schematically the definitions of target area, $A_t$, and substrate holder area, $A_s$.

DETAILED DESCRIPTION OF THE INVENTION

According to the present invention there is provided a method for coating cutting tools for machining by chip removal. The cutting tool comprises a body of a hard alloy of cemented carbide, cermet, ceramics, cubic boron nitride based material or high speed steel with a hard and wear resistant refractory coating. The wear resistant coating is composed of one or more layers of which at least one comprises a low compressive stressed metal nitride deposited by reactive magnetron sputtering i.e. MeN and/or $Me_2N$, where Me is one or more of the elements Sc, Y, Ti, Zr, Hf, V, Nb, Ta, Cr, Si, Al and B. The total amount of Al and/or Si and/or Cr, and/or B is preferably more than 40 at%, most preferably more than 60 at%. The B content should, however, be less than 10 at%. The rest of the layer(s), if any at all, are composed of metal nitrides and/or carbides and/or oxides with the elements chosen from Ti, Zr, Hf, V, Nb, Ta, Cr, W, Si and Al.

Characteristic for the method of the present invention is that the ratio between the area of the target, $A_t$, and the area of the substrate holder facing the target, $A_s$, defined as $R=A_t/A_s$ is considerably larger than that commonly used in the process of depositing wear resistant coatings onto tools for machining by chip removal. According to the invention, R>0.7 and preferably R>1.0 most preferably R>1.5. In addition, the distance from the target surface to the substrate surface, $d_t$, is small, compared to the extension of the target. The extension of the target can be approximated with the square root of the target area, then the distance is $d_t < (A_t)^{0.5}$ and preferably $d_t < 0.7*(A_t)^{0.5}$. In this way it is possible to deposit coatings with good uniformity all around the tool without the use of substrate rotation. This method minimises the amount of microstructural defects in the layers, which are induced during the coating-off periods, resulting in a coating with superior mechanical properties compared to coatings produced when rotating fixtures are used.

Since the area ratio, R, is large, a positive bias, $V_s>0$, can be used, which is not possible in industrial deposition. If this condition is not fulfilled an extreme bias power supply is required and the plasma will be drained of electrons, which will stop the sputtering process. By applying a positive substrate bias, the deposition condition will change, so that there will be a net electron current from the plasma to the substrate holder. This is contradictory to the situation when a negative substrate bias is applied, which gives a net ion current from plasma to the substrate. The electron current density $\varphi_s = I_s/A_s$ is larger than 10 mA/cm$^2$ and preferably larger than 30 mA/cm$^2$. The high electron current density is a key factor in the present invention. The electron current increases the surface mobility of atoms and thereby decreases the generation rate of lattice defects, which are responsible for the compressive residual stress state in PVD coatings. By enhancing the surface mobility, layers with low compressive residual stresses can be deposited. Also the high electron current increases dissociation of the nitrogen molecules into atomic nitrogen. This effect eliminates the usual difficulties of achieving the correct stoichiometry of nitride coatings, normally associated to reactive magnetron sputtering. Using the present invention, nitrogen saturated nitride coatings are obtained in a wide range of nitrogen flow rates from 20 sccm up to more than 175 sccm (standard cubic centimetre per minute) at an Ar pressure of 0.25 Pa.

The use of a high ratio R in the present inventions should result in a very low productivity and therefore an unrealistic high production cost. However, by depositing the coatings (unconventionally) close to the target surface, a very high deposition rate is obtained. This extreme deposition rate will lower the production cost and make the method economically profitable. The deposition rate should be between 2 and 14 nm/s, preferably between 4 and 8 nm/s. If the deposition rate is to high, e.g. greater than 20 nm/s, the defect content of the layer will increase and this will be associated with an increased compressive residual stress state.

The average surface mobility of the elements should be adjusted in relation to the deposition rate of the process, i.e. at higher deposition rate, a higher surface mobility is required to keep the stresses at a low level. This could be adjusted by increasing the bulk temperature and/or by adjusting the composition of the sputtered flux. Of course, when optimising the composition, consideration shall also be made with respect to the mechanical properties of the final layer. In order to get a good surface atom mobility of the composition of the sputtered flux and consequently the sputtering target should comprise more than 40 at% Al and/or Si and/or Cr and/or B and preferably more than 60 at%. The B content should, however, be less than 10 at%.

In one embodiment thick MeN and/or $Me_2N$-layers are deposited directly onto a cutting tool substrate as mentioned above. The thickness of each individual layer then varies from 5 to 100 μm preferably from 5 to 50 μm, for metal machining when high wear resistance is desired.

In another embodiment, further layers of metal nitrides and/or carbides and/or oxides with the metal elements selected from Ti, Nb, Hf, V, Ta, Mo, Zr, Cr, W and Al are deposited together with the MeN and/or $Me_2N$-layer. The total

coating thickness then varies from 5 to 100 $\mu$m, preferably from 5 to 50 $\mu$m, with the thickness of the non MeN and/or Me$_2$N, - layer(s) varying from 0.1 to 15 $\mu$m.

In yet another embodiment, thin layers (0.2 - 5 $\mu$m) with an increased effective adhesion can be deposited, using the invented method of deposition. Such layers can be used in applications where the demand on adhesion of the layer is particularly important. Examples of layers with increased effective adhesion includes layers having compositions comprising (Ti,Al)N, (Ti,Al,Cr)N, (Al,Cr)N, (Ti,Al,Si)N, (Ti,Al,Cr,Si)N, (Ti,Si)N, (Cr,Si)N.

According to the method of the present invention low compressive stress nitride layer, e.g. MeN and/or Me$_2$N layers are deposited by reactive magnetron sputtering using the following characteristics:

Magnetron power density: 3.1 W/cm$^2$ to 63 W/cm$^2$, preferably 9.4 W/cm$^2$ to 19 W/cm$^2$.

Substrate current density I$_s$/A$_s$: >10 mA/cm$^2$, preferably 10 mA/cm$^2$ to 1500 mA/cm$^2$, most preferably 30 mA/cm$^2$ to 750 mA/cm$^2$.

Atmosphere: mixture of Ar and N$_2$ mixture or pure N$_2$

Total pressure: <5 Pa

Bias voltage V$_s$: >0 preferably > +5 V but < +60 V.

Geometrical arrangements:

- Target to substrate area; R= A$_t$ / A$_s$: R>0.7, preferably>1.0, most preferably >1.5
- Target to substrate distance: d$_t$< (A$_t$)$^{0.5}$, preferably d$_t$< 0.7*(A$_t$)$^{0.5}$, most preferably d$_t$< 0.7*(A$_t$)$^{0.5}$

    The sputtering target preferably contains more than 40 at% Al and/or Si and/or Cr and/or B, more preferably more than 60 at%. The B content should, however, be less than 10 at%.

Without limiting the invention to any particular theory, it is believed that the advantage of the present invention is due to a combination of several effects:

- The area relation between the target and the substrate holder, in combination with the close distance from the target to the substrate, gives an advantage of a high deposition rate with good coating thickness uniformity around the tool in absence of coating-off periods. This gives a coating with minimised amount of microstructural defects, interlayers and re-nucleation zones, caused by residual gases.
- The area relation between the target and the substrate holder makes it possible to use a positive substrate bias. The positive substrate bias gives three-fold advantage due to the high electron current density:

    Increased surface mobility of adatoms minimises the microstructural defects and thereby the compressive residual stress.

- Increased dissociation rate of nitrogen molecules into atomic nitrogen makes it easier to achieve desired stoichiometric composition of the layer.
- Increased desorption rate of absorbed hydrogen and/or water molecules from the surface would decrease the formation rate of hydroxide based defect complex, which contribute to high compressive stresses in some coating material systems.
- By using a target composition that is tailored for a high surface mobility of the adatoms, the associated risk of high compressive stress due to the high deposition rate is minimised.

The present invention has been described with reference to a reactive magnetron sputtering method for deposition of MeN and/or Me$_2$N layer(s). It is obvious that the method can also be applied to the deposition of other coating material based on metal carbonitrides and/or carbooxynitrides and/or oxynitrides with the metal elements chosen from Ti, Zr, Hf, V, Nb, Ta, Cr, W, Si and Al by adding carbon and/or oxygen containing gas.

Example 1

(Ti,Al)N-layers were deposited in a deposition system equipped with a rectangular dc magnetron sputter source with a Ti + Al target (50 at% Ti + 50 at% Al) of 318 cm$^2$. The substrate table projected surface area was 20 cm$^2$ positioned at a distance of 5 cm from the target surface.

Mirror-polished cemented carbide substrates with composition 6 wt% Co and 94 wt% WC were used. The WC grain size was about 1 $\mu$m and the hardness was 1650 HV$_{10}$.

Before deposition, the substrates were cleaned in an ultrasonic bath of an alkali solution and in alcohol. The substrates were stationarily positioned above the magnetron and resistively heated by an electron beam for 40 min to about 400°C. Immediately after heating, the substrates were argon-ion etched (ion current density 5 mA/cm$^2$) for 30

minutes using a substrate bias of -200V. The subsequent (Ti,Al)N deposition was carried out by reactive magnetron sputtering using a magnetron power of 5 kW, an Ar pressure of 0.3 Pa, a nitrogen flow rate of 100 sccm. The substrate bias voltages, $V_s$, were varied in three different deposition processes: -100V, -50V and +50V. The resulting thickness of the positively biased layers was ~ 5 $\mu$m after 20 min of deposition corresponding to a deposition rate of 4,2 nm/s. The substrate temperature was measured with a thermocouple attached to the substrate holder. The temperatures were approximately 400°C (using negative bias) to 500°C (using positive bias) at the end of the reactive deposition period.

The substrate current $I_s$ was +1.2 A for negative $V_s$, irrespective of voltage. When changing from negative to positive $V_s$ the substrate current changed sign from positive to negative and become around -10 A corresponding to electron current of 500 mA/cm$^2$.

XRD analysis showed that all layers exhibited the cubic sodium chloride structure (Ti,Al)N with a lattice parameter of about 4.18 Å.

By applying a positive $V_s$, a layer with low compressive residual stress states, $\sigma_{tot} \approx$ +0.6 GPa, was obtained measured using the XRD sin$^2\phi$ method. The thermal stresses, $\sigma_{thermal}$, can be calculated using

$$\sigma_{thermal} = \frac{E_f}{(1-\nu_f)} \cdot (\alpha_f - \alpha_{sub}) \cdot (T_{dep} - T_{ana})$$

where $E_f$ and $\nu_f$ are the Young's modulus and Poisson's ratio of the layer, respectively. $\alpha_f$ and $\alpha_{sub}$ the coefficient of thermal expansion of the layer and substrate material. $T_{dep}$ and $T_{ana}$ are the deposition temperature and analyse temperature in K. Using $\alpha_{sub} = 4.8 \times 10^{-6}$, $\alpha_{(Ti,Al)N,a} = 9.35 \times 10^{-6}$, $E_f$ = 450 GPa, $\nu_f$ = 0.22, $T_{dep}$ = 773 K, $T_{ana}$ = 298 K in the equation above gives $\sigma_{thermal}$ = +1.2 GPa. The intrinsic stress can then be obtained by applying the equation:

$$\sigma_{int} = \sigma_{tot} - \sigma_{thermal}$$

The intrinsic stress, $\sigma_{int}$, of coatings deposited with positive bias is therefore: $\sigma_{int}$ = +0.6 - 1.2 = -0.6 GPa, i.e. those coatings are grown in a low compressive intrinsic stress mode.

Using negative $V_s$ gave layers with total residual stresses in the range of approximately -2 GPa.

Adhesion testing by Rockwell indentation displayed that the adhesion was acceptable for all layers. There was no significant difference in adhesion between variant A and D, but since D, present invention, has almost three times thicker coating the results are extremely good. The indentation test demonstrates that the layer according to the present invention has strongly enhanced toughness properties compared to layers grown using negative bias and state of the art.

Table 1. Properties of the (Ti,Al)N layers.

| Variant | $V_s$ [V] | Deposition rate (nm/s) | Coating Thickness [um] | HR$_C$ | σ [GPa] |
|---|---|---|---|---|---|
| A | Prior art | 0.8 | 2.4 | Good | -3.8 |
| B | -100V | 4.3 | 5.1 | Acceptable | -2.1 |
| C | -50V | 4.5 | 5.4 | Acceptable | -1.7 |
| D Present invention | +50V | 5.1 | 6.1 | Good | +0.6 |

Example 2

In order to determine the correct N$_2$ flow rate to get a stoichiometric ratio between the metallic elements and nitrogen i.e. (Ti+Al)/N ~ 1, a test was performed where the N$_2$ flow rate was varied between 10 and 175 sccm. All other deposition data was kept constant i.e. the magnetron power at 5 kW, the substrate bias at +50V, Ar pressure at 0.25 Pa. The deposition system set-up was the same as in example 1. The content of Al, Ti and N in the layers was measured using EDS. The results are reported in table 2 below and show that using the present invention a surprisingly high stability for the N$_2$ flow rate is achieved. In the whole range between 30 sccm and 175 sccm, a stoichiometric composition is obtained. This is an effect of the high substrate electron current, increasing the dissociation rate of the N$_2$ molecule. No Ar could be detected in any of the layers.

Table 2. Dependence of $N_2$ flow rate on the stoichiometry ratio (Ti+Al)/N

| Variant | $N_2$ flow rate [sccm] | Ti [at%] | Al [at%] | N [at%] | Stoichiometry ratio (Ti+Al)/N |
|---------|------------------------|----------|----------|---------|-------------------------------|
| E | 10 | 41 | 40 | 19 | 4.40 |
| F | 20 | 33 | 32 | 35 | 1.85 |
| G | 30 | 24 | 27 | 50 | 1.02 |
| H | 40 | 24 | 26 | 49 | 1.03 |
| I | 50 | 24 | 28 | 48 | 1.09 |
| J | 75 | 26 | 26 | 48 | 1.08 |
| K | 100 | 25 | 27 | 47 | 1.11 |
| L | 125 | 23 | 26 | 50 | 0.98 |
| M | 150 | 23 | 26 | 51 | 0.95 |
| N | 175 | 23 | 26 | 51 | 0.95 |

Example 3

Cemented carbide cutting tool inserts from example 1 (the same names of the variants are used) were used in a face milling cutting test, in solid and slotted work piece material, SS2541. The homogeneous cutting test (solid work piece) was made in a 60 mm wide plate and the interrupted cutting test was performed by using three 20 mm wide plates separated by 10 mm, mounted as a package. The cutting data were; $v_c$ = 250 m/min (homogeneous) and 200 m/min (interrupted), f = 0.1 mm/rev and depth of cut = 2.5 mm.

| Variant | | Homogeneous cut Tool life, mm | Interrupted cut Tool life, mm |
|---------|---|-------------------------------|-------------------------------|
| A | Prior art (Ti,Al)N | 2200 | 1500 |
| B | (Ti,Al)N ($V_s$ = -100 V) | 1700 | 900 |
| D | Present invention (Ti,Al)N ($V_s$ = +50 V) | 2800 | 2100 |

This test demonstrates that the variant D shows the best wear resistance, but also surprisingly the best toughness in spite of the thickest coating.

**Claims**

1.  A method of depositing using reactive magnetron sputtering a nitride based wear resistant layer on a cutting tool for machining by chip removal **characterised in**:

    - a deposition rate, $t_d$, higher than 2 nm/s
    - a positive bias voltage, $V_s$ between +1 V and +60 V applied to the substrate, in respect to ground potential
    - a substrate current density, $I_s/A_s$, larger than 10 mA/cm$^2$
    - a target surface area, $A_t$, larger than 0,7 times the substrate surface area, $A_s$, i.e. R=$A_t/A_s$>0,7 and
    - a distance between the target surface and the substrate surface, $d_t$, < $(A_t)^{0.5}$

2.  A method according to claim 1, **characterised in that**

    - R> 1.0 and
    - $d_t$< $0.7*(A_t)^{0.5}$

3.  A method according to claim 1, **characterised in that**

- R> 1, 5 and
- $d_t < 0.5*(A_t)^{0.5}$

**4.** A method according to any of preceding claims, **characterised in that** the substrate current density, $I_s/A_s$ is larger than 30 mA/cm$^2$

**5.** A method according to any of preceding claims, **characterised in that** the deposition rate, $t_d$, is higher than 3 nm/s.

**6.** A method according to any of preceding claims, **characterised in that** the nitride layer is MeN and/or Me$_2$N, where Me is one or more of the elements Sc, Y, Ti, Zr, Hf, V, Nb, Ta, Cr, Si, Al and B.

**7.** A method according to any of preceding claims, **characterised in that** the nitride layer contains a total amount of Al and/or Si and/or Cr and/or B of at least 40 at% however with a maximum of 10 at% B.

**Patentansprüche**

**1.** Abscheideverfahren unter Verwendung von reaktivem Magnetron-Sputtern einer abriebbeständigen Schicht auf ein Schneidwerkzeug für die spanabhebende Bearbeitung, **gekennzeichnet durch**:

- eine Abscheidegeschwindigkeit $t_d$ von mehr als 2 nm/s,
- eine bezüglich des Massepotentials positive Vorspannung $V_s$ zwischen +1 V und +60 V, die an das Substrat angelegt wird,
- eine Substratstromdichte $I_s/A_s$ von mehr als 10 mA/cm$^2$,
- einen Zielflächenbereich $A_t$ von mehr als 0,7-mal dem Substratflächenbereich $A_s$, d.h. R = $A_t/A_s$ > 0,7, und
- einem Abstand $d_t$ zwischen der Zielfläche und der Substratfläche < $(A_t)^{0,5}$.

**2.** Verfahren nach Anspruch 1, **dadurch gekennzeichnet, daß**

- R > 1,0 und
- $d_t < 0,7 * (A_t)^{0,5}$.

**3.** Verfahren nach Anspruch 1, **dadurch gekennzeichnet, daß**

- R > 1,5 und
- $d_t < 0,5 * (A_t)^{0,5}$.

**4.** Verfahren nach einem der vorangegangenen Ansprüche, **dadurch gekennzeichnet, daß** die Substratstromdichte $I_s/A_s$ größer als 30 mA/cm$^2$ ist.

**5.** Verfahren nach einem der vorangegangenen Ansprüche, **dadurch gekennzeichnet, daß** die Abscheidegeschwindigkeit $d_t$ größer als 3 nm/s ist.

**6.** Verfahren nach einem der vorangegangenen Ansprüche, **dadurch gekennzeichnet, daß** die Nitridschicht MeN und/oder Me$_2$N ist, wobei Me eines oder mehrere der Elemente Sc, Y, Ti, Zr, Hf, V, Nb, Ta, Cr, Si, Al und B ist.

**7.** Verfahren nach einem der vorangegangenen Ansprüche, **dadurch gekennzeichnet, daß** die Nitridschicht eine Gesamtmenge von Al und/oder Si und/oder Cr und/oder B von wenigstens 40 At.-%, jedoch maximal 10 At.-% B enthält.

**Revendications**

**1.** Procédé de dépôt, utilisant une pulvérisation par magnétron réactive, d'une couche résistant à l'usure à base de nitrure sur un outil de coupe pour un usinage par enlèvement de copeaux, **caractérisé par** :

- une vitesse de dépôt $t_d$ supérieure à 2 nm/s
- une tension de polarisation positive, $V_s$ entre + 1 V et + 60 V appliquée au substrat, par rapport au potentiel de masse
- une densité de courant de substrat, $I_s/A_s$, supérieure à 10 mA/cm$^2$
- une aire de surface cible, $A_t$, supérieure à 0,7 fois l'aire de surface du substrat, $A_s$, c'est-à-dire $R = A_t/A_s > 0,7$ et
- une distance entre la surface cible et la surface du substrat, $d_t$, $< (A_t)^{0,5}$

2. Procédé selon la revendication 1, **caractérisé en ce que**

    - $R > 1,0$ et
    - $d_t < 0,7*(A_t)^{0,5}$

3. Procédé selon la revendication 1, **caractérisé en ce que**

    - $R > 1,5$, et
    - $d_t < 0,5*(A_t)^{0,5}$

4. Procédé selon l'une quelconque des revendications précédentes, **caractérisé en ce que** la densité de courant de substrat, $I_s/A_s$ est supérieure à 30 mA/cm$^2$.

5. Procédé selon l'une quelconque des revendications précédentes, **caractérisé en ce que** la vitesse de dépôt, $t_d$, est supérieure à 3 nm/s.

6. Procédé selon l'une quelconque des revendications précédentes, **caractérisé en ce que** la couche de nitrure est faite de MeN et/ou Me$_2$N, où Me est un ou plusieurs des éléments Sc, Y, Ti, Zr, Hf, V, Nb, Ta, Cr, Si, Al, et B.

7. Procédé selon l'une quelconque des revendications précédentes, **caractérisé en ce que** la couche de nitrure contient une proportion totale de Al et/ou Si et/ou Cr et/ou B d'au moins 40 % atomique avec cependant un maximum de 10 % atomique de B.

Figure 1:

$A_s$

$A_t$

Figure 2